# EUROPEAN PATENT APPLICATION

(11) **EP 4 746 613 A1**
(43) Date of publication of application: **20.05.2026**
(21) Application number: 25202393.2
(22) Date of filing: 16.09.2025
(51) Int. Cl.: H10B 12/00

(54) **SYSTEMS AND METHODS OF SELECTIVE METAL DEPOSITION FOR MEMORY CELL TRANSISTORS**

(30) Priority: 13.11.2024 US 202463720164 P; 20.11.2024 US 202463723110 P; 20.11.2024 US 202463723112 P; 03.04.2025 US 202519170057
(71) Applicant: Samsung Electronics Co., Ltd., Suwon-si, Gyeonggi-do 16677 (KR)
(72) Inventor: AGRAWAL, Nidhi, San Jose, CA, 95134 (US); KANAGO, Anthony James, San Jose, CA, 95134 (US); LEE, Siwoo, San Jose, CA, 95134 (US)
(74) Representative: Kuhnen & Wacker Patent- und Rechtsanwaltsbüro PartG mbB

(57) **Abstract**

Provided are systems, methods, and apparatuses of selective metal deposition for memory cell transistors. In one or more examples, the systems, devices, and methods include forming (1005) a first insulator, a second insulator, and a semiconductor channel of the transistor; forming (1010) a recess based on removing a portion of the first insulator; forming (1015) a dielectric layer over at least one of a surface of the first insulator, a surface of the second insulator, a surface of the recess, or a surface of the semiconductor channel; forming (1020) a first metal layer over the dielectric layer; removing (1025) a first portion of the first metal layer; and selectively forming (1030) a second metal layer on the first metal layer in the recess.

## Description

### TECHNICAL FIELD

The disclosure relates generally to memory systems. In particular, the subject matter relates to systems and methods of selective metal deposition for memory cell transistors.

### BACKGROUND

The present background section is intended to provide context only, and the disclosure of any concept in this section does not constitute an admission that said concept is prior art.

A dynamic random-access memory (DRAM) cell may include a transistor and a capacitor. The transistor can act as a switch, controlling access to the capacitor where a data bit may be stored. The transistor can act as a gate that determines when the capacitor can be accessed to read or write data. When a voltage is applied to the transistor's gate, the transistor turns on, allowing current to flow through the channel and connect the capacitor to the bit line. When the gate voltage is removed, the transistor turns off, isolating the capacitor and preserving the stored charge. Since the capacitor may slowly leak charge over time, the transistor can periodically refresh the data by reading and rewriting the stored value to maintain data integrity.

### SUMMARY

**In** various embodiments, the systems and methods described herein include systems, methods, and apparatuses of selective metal deposition for memory cell transistors. In some aspects, the techniques described herein relate to a method of fabrication of a transistor of a memory cell, the method including: forming a first insulator, a second insulator, and a semiconductor channel of the transistor; forming a recess based on removing a portion of the first insulator; forming a dielectric layer over at least one of a surface of the first insulator, a surface of the second insulator, a surface of the recess, or a surface of the semiconductor channel; forming a first metal layer over the dielectric layer; removing a first portion of the first metal layer; and selectively forming a second metal layer on the first metal layer in the recess.

In some aspects, the techniques described herein relate to a method, wherein a second portion of the first metal layer remains in the recess after removing the first portion of the first metal layer.

In some aspects, the techniques described herein relate to a method, wherein the second portion of the first metal layer is a seed layer of the second metal layer.

In some aspects, the techniques described herein relate to a method, wherein the first metal layer in the recess is a seed that enables the second metal layer to grow between the semiconductor channel and an inter-tier dielectric that extends from the first insulator.

In some aspects, the techniques described herein relate to a method, wherein the recess is formed between a portion of the second insulator and a portion of the inter-tier dielectric.

In some aspects, the techniques described herein relate to a method, wherein the recess is adjacent to an end portion of the second insulator that is adjacent to the semiconductor channel.

In some aspects, the techniques described herein relate to a method, wherein the dielectric layer is formed as a gate oxide of the transistor.

In some aspects, the techniques described herein relate to a method, further including forming a spacer capping over the second metal layer and the dielectric layer.

In some aspects, the techniques described herein relate to a method, wherein at least one of the first insulator or the second insulator includes at least one of a nitride insulator or an oxide insulator.

In some aspects, the techniques described herein relate to a method, wherein: at least a portion of the second insulator is formed adjacent to the first insulator and a semiconductor that includes the semiconductor channel.

In some aspects, the techniques described herein relate to a device including: a first insulator; an inter-tier dielectric extending from the first insulator; a second insulator formed adjacent to the first insulator; a semiconductor channel formed adjacent to the second insulator; a recess that is formed based on removing a portion of the first insulator; a dielectric layer formed over at least one of a surface of the first insulator, a surface of the second insulator, a surface of the recess, or a surface of the semiconductor channel; a first metal layer formed in the recess; and a second metal layer selectively formed on the first metal layer in the recess.

In some aspects, the techniques described herein relate to a device, wherein a second portion of the first metal layer remains in the recess based on forming a first portion and the second portion of the first metal layer over the dielectric layer and removing the first portion of the first metal layer.

In some aspects, the techniques described herein relate to a device, wherein the second portion of the first metal layer is a seed layer of the second metal layer.

In some aspects, the techniques described herein relate to a device, wherein the first metal layer in the recess is a seed layer that enables the second metal layer to grow between the semiconductor channel and an inter-tier dielectric that extends from the first insulator.

In some aspects, the techniques described herein relate to a device, wherein the recess is formed between a portion of the second insulator and a portion of the inter-tier dielectric.

In some aspects, the techniques described herein relate to a device, wherein the recess is adjacent to an end portion of the second insulator that is adjacent to the semiconductor channel.

In some aspects, the techniques described herein relate to a device, wherein the dielectric layer is formed as a gate oxide of a transistor of the device.

In some aspects, the techniques described herein relate to a fabrication system including: a deposition controller to: form a first insulator, a second insulator, and a semiconductor channel of a transistor; form a recess based on removing a portion of the first insulator; form a dielectric layer over at least one of a surface of the first insulator, a surface of the second insulator, a surface of the recess, or a surface of the semiconductor channel; and form a first metal layer over the dielectric layer; and a removal controller to remove a first portion of the first metal layer; and the deposition controller to selectively form a second metal layer on the first metal layer in the recess.

In some aspects, the techniques described herein relate to a fabrication system, wherein a second portion of the first metal layer remains in the recess after removing the first portion of the first metal layer.

In some aspects, the techniques described herein relate to a fabrication system, wherein the second portion of the first metal layer is a seed layer of the second metal layer.

A computer-readable medium is disclosed. The computer-readable medium can store instructions that, when executed by a computer, cause the computer to perform substantially the same or similar operations as described herein. Similarly, non-transitory computer-readable media, devices, and systems for performing substantially the same or similar operations as described herein are further disclosed.

The systems and methods described herein include multiple advantages and benefits. For example, the systems and methods described herein may include forming a thicker dielectric layer (e.g., thicker gate oxide) for leakage reduction near the cap-edge and filling a recess with a first metal layer (e.g., TiN seed layer) to deposit a second metal (e.g., molybdenum) for the gate of the transistor, which helps reduce wordline (WL) resistance as well as provide a higher work-function that increases a threshold voltage of the transistor, making it easier to distinguish between zeros and ones stored in memory cells. Moreover, using selective deposition to deposit the second metal (e.g., molybdenum) is a relatively low-cost and low-complexity fabrication process, making it a cost-effective solution to lowering resistivity, which helps increase DRAM switch speeds. Increasing DRAM switch speeds provides faster data transfer rates, meaning the DRAM can read and write information significantly quicker, leading to improved overall system performance, especially in memory-intensive tasks, such as artificial intelligence (AI) computing, gaming, video editing, multitasking, etc.

### BRIEF DESCRIPTION OF THE DRAWINGS

These and other features and advantages of the present disclosure will be appreciated and understood with reference to the specification, claims, and appended drawings, wherein:
FIG. 1 illustrates a cross-sectional view illustrating an example of a semiconductor device in accordance with one or more implementations as described herein.
FIG. 2 illustrates a three-dimensional view illustrating an example of a semiconductor device in accordance with one or more implementations as described herein.
FIG. 3 illustrates a cross-sectional view illustrating an example of a semiconductor device in accordance with one or more implementations as described herein.
FIG. 4 illustrates a cross-sectional view illustrating an example of a semiconductor device in accordance with one or more implementations as described herein.
FIG. 5 illustrates a cross-sectional view illustrating an example of a semiconductor device in accordance with one or more implementations as described herein.
FIG. 6 illustrates a cross-sectional view illustrating an example of a semiconductor device in accordance with one or more implementations as described herein.
FIG. 7 illustrates a cross-sectional view illustrating an example of a semiconductor device in accordance with one or more implementations as described herein.
FIG. 8 illustrates a cross-sectional view illustrating an example of a semiconductor device in accordance with one or more implementations as described herein.
FIG. 9 depicts a flow diagram illustrating an example method associated with the disclosed systems, in accordance with example implementations described herein.
FIG. 10 depicts a flow diagram illustrating an example method associated with the disclosed systems, in accordance with example implementations described herein.
FIG. 11 illustrates an example system in accordance with one or more implementations as described herein.

While the present systems and methods are susceptible to various modifications and alternative forms, specific embodiments thereof are shown by way of example in the drawings and will herein be described. The drawings may not be to scale. It should be understood, however, that the drawings and detailed description thereto are not intended to limit the present systems and methods to the particular form disclosed, but to the contrary, the intention is to cover all modifications, equivalents, and alternatives falling within the scope of the present systems and methods as defined by the appended claims.

### DETAILED DESCRIPTION OF VARIOUS EMBODIMENTS

Various embodiments of the present disclosure now will be described more fully hereinafter with reference to the accompanying drawings. Indeed, the disclosure may be embodied in many forms and should not be construed as limited to the embodiments set forth herein; rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Like numbers refer to like elements throughout. Arrows in each of the figures depict bi-directional data flow and/or bi-directional data flow capabilities. The terms "path," "pathway" and "route" are used interchangeably herein.

Embodiments of the present disclosure may be implemented in various ways, including as computer program products that comprise articles of manufacture. A computer program product may include a non-transitory computer-readable storage medium storing applications, programs, program components, scripts, source code, program code, object code, byte code, compiled code, interpreted code, machine code, executable instructions, and/or the like (also referred to herein as executable instructions, instructions for execution, computer program products, program code, and/or similar terms used herein interchangeably). Such non-transitory computer-readable storage media include all computer-readable media (including volatile and non-volatile media).

In one embodiment, a non-volatile computer-readable storage medium may include a floppy disk, flexible disk, hard disk, solid-state storage (SSS) (for example a solid-state drive (SSD)), solid state card (SSC), solid state module (SSM), enterprise flash drive, magnetic tape, or any other non-transitory magnetic medium, and/or the like. A non-volatile computer-readable storage medium may include a punch card, paper tape, optical mark sheet (or any other physical medium with patterns of holes or other optically recognizable indicia), compact disc read only memory (CD-ROM), compact disc-rewritable (CD-RW), digital versatile disc (DVD), Blu-ray disc (BD), any other non-transitory optical medium, and/or the like. Such a non-volatile computer-readable storage medium may include read-only memory (ROM), programmable read-only memory (PROM), erasable programmable read-only memory (EPROM), electrically erasable programmable read-only memory (EEPROM), flash memory (for example Serial, NAND, NOR, and/or the like), multimedia memory cards (MMC), secure digital (SD) memory cards, SmartMedia cards, CompactFlash (CF) cards, Memory Sticks, and/or the like. Further, a non-volatile computer-readable storage medium may include conductive-bridging random access memory (CBRAM), phase-change random access memory (PRAM), ferroelectric random-access memory (FeRAM), non-volatile random-access memory (NVRAM), magnetoresistive random-access memory (MRAM), resistive random-access memory (RRAM), Silicon-Oxide-Nitride-Oxide-Silicon memory (SONOS), floating junction gate random access memory (FJG RAM), Millipede memory, racetrack memory, and/or the like.

In one embodiment, a volatile computer-readable storage medium may include random access memory (RAM), dynamic random access memory (DRAM), static random access memory (SRAM), fast page mode dynamic random access memory (FPM DRAM), extended data-out dynamic random access memory (EDO DRAM), synchronous dynamic random access memory (SDRAM), double data rate synchronous dynamic random access memory (DDR SDRAM), double data rate type two synchronous dynamic random access memory (DDR2 SDRAM), double data rate type three synchronous dynamic random access memory (DDR3 SDRAM), Rambus dynamic random access memory (RDRAM), Twin Transistor RAM (TTRAM), Thyristor RAM (T-RAM), Zero-capacitor (Z-RAM), Rambus in-line memory component (RIMM), dual in-line memory component (DIMM), single in-line memory component (SIMM), video random access memory (VRAM), cache memory (including various levels), flash memory, register memory, and/or the like. It will be appreciated that where embodiments are described to use a computer-readable storage medium, other types of computer-readable storage media may be substituted for or used in addition to the computer-readable storage media described above.

As should be appreciated, various embodiments of the present disclosure may be implemented as methods, apparatuses, systems, computing devices, computing entities, and/or the like. As such, embodiments of the present disclosure may take the form of an apparatus, system, computing device, computing entity, and/or the like executing instructions stored on a computer-readable storage medium to perform certain steps or operations. Thus, embodiments of the present disclosure may take the form of a hardware embodiment, a computer program product embodiment, and/or an embodiment that comprises a combination of computer program products and hardware performing certain steps or operations.

Embodiments of the present disclosure are described below with reference to block diagrams and flowchart illustrations. Thus, it should be understood that each block of the block diagrams and flowchart illustrations may be implemented in the form of a computer program product, a hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially, such that one instruction is retrieved, loaded, and executed at a time. In some example embodiments, retrieval, loading, and/or execution may be performed in parallel, such that multiple instructions are retrieved, loaded, and/or executed together. Thus, such embodiments can produce specifically configured machines performing the steps or operations specified in the block diagrams and flowchart illustrations. Accordingly, the block diagrams and flowchart illustrations support various combinations of embodiments for performing the specified instructions, operations, or steps.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not be necessarily all referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. Similarly, various waveforms and timing diagrams are shown for illustrative purpose only. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on chip (SoC), an assembly, and so forth.

The provided description is presented to enable one of ordinary skill in the art to make and use the subject matter disclosed herein and to incorporate it in the context of particular applications. While the following is directed to specific examples, other and further examples may be devised without departing from the basic scope thereof.

Various modifications, as well as a variety of uses in different applications, will be readily apparent to those skilled in the art, and the general principles defined herein may be applied to a wide range of embodiments. Thus, the subject matter disclosed herein is not intended to be limited to the embodiments presented, but is to be accorded the widest scope consistent with the principles and novel features disclosed herein.

In the description provided, numerous specific details are set forth in order to provide a more thorough understanding of the subject matter disclosed herein. It will, however, be apparent to one skilled in the art that the subject matter disclosed herein may be practiced without necessarily being limited to these specific details. In other instances, well-known structures and devices are shown in block diagram form, rather than in detail, in order to avoid obscuring the subject matter disclosed herein.

All the features disclosed in this specification (e.g., any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described herein with reference to the figures. It should be noted that the figures are only intended to facilitate the description of the features. The various features described are not intended as an exhaustive description of the subject matter disclosed herein or as a limitation on the scope of the subject matter disclosed herein. Additionally, an illustrated example need not have all the aspects or advantages shown. An aspect or an advantage described in conjunction with a particular example is not necessarily limited to that example and can be practiced in any other examples even if not so illustrated, or if not so explicitly described.

It is noted that, if used, the labels left, right, front, back, top, bottom, forward, reverse, clockwise and counterclockwise have been used for convenience purposes only and are not intended to imply any particular fixed direction. Instead, the labels are used to reflect relative locations and/or directions between various portions of an object.

Moreover, the terms "system," "component," "module," "interface," "model," or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution and a component may be localized on one computer and/or distributed between two or more computers.

Unless explicitly stated otherwise, each numerical value and range may be interpreted as being approximate, as if the word "about" or "approximately" preceded the value of the value or range. Signals and corresponding nodes or ports might be referred to by the same name and are interchangeable for purposes here.

While embodiments may have been described with respect to circuit functions, the embodiments of the subject matter disclosed herein are not limited. Possible implementations may be embodied in a single integrated circuit, a multi-chip module, a single card, SoC, or a multi-card circuit pack. As would be apparent to one skilled in the art, the various embodiments might also be implemented as part of a larger system. Such embodiments may be employed in conjunction with, for example, a digital signal processor, microcontroller, field-programmable gate array, application-specific integrated circuit, or general-purpose computer.

As would be apparent to one skilled in the art, various functions of circuit elements may also be implemented as processing blocks in a software program. Such software may be employed in, for example, a digital signal processor, microcontroller, or general-purpose computer. Such software may be embodied in the form of program code embodied in tangible media, such as magnetic recording media, optical recording media, solid-state memory, floppy diskettes, CD-ROMs, hard drives, or any other non-transitory machine-readable storage medium, that when the program code is loaded into and executed by a machine, such as a computer, the machine becomes an apparatus for practicing the subject matter disclosed herein. When implemented on a general-purpose processor, the program code segments combine with the processor to provide a unique device that operates analogously to specific logic circuits. Described embodiments may also be manifest in the form of a bit stream or other sequence of signal values electrically or optically transmitted through a medium, stored magnetic-field variations in a magnetic recording medium, etc., generated using a method and/or an apparatus as described herein.

The systems and methods described herein may incorporate and/or may be based on 3D DRAM. A memory cell of DRAM may include one capacitor and one transistor. A planar DRAM may include a two-dimensional area of such memory cells (e.g., memory cells formed in an X dimension and Y dimension). 3D DRAM may extend memory cells in a third dimension, or vertically relative to the two-dimensions of planar DRAM. For example, 3D DRAM may form memory cells in an X dimension, Y dimension, and Z dimension. Thus, 3D DRAM can refer to a type of DRAM where the memory cells are stacked vertically on top of each other, allowing for significantly higher storage density compared to planar DRAM by utilizing the third dimension to increase data storage capacity. Higher-density DRAMs provide more memory per watt, which helps datacenters with power consumption and heat dissipation.

Some DRAM architectures may be based on gate-all-around (GAA) transistors. The gate material of a GAA transistor can surround the conducting channel from all sides, which can enable continuous scaling. In some cases, GAA transistors can be used in vertical stacking of memory cells (e.g., 3D DRAM). However, 3D DRAM can suffer from relatively high wordline resistance for the GAA cell gate. Some DRAM architectures may use titanium nitride (TiN) for the gate metal because TiN can form a reliable interface with silicon dioxide (SiO2), is thermally stable, induces fewer traps than other gate metals (e.g., relatively low number of material defects), and is reasonably reliable (e.g., relatively low time-dependent dielectric breakdown), etc. There are relatively few metals than can provide better performance than TiN.

One metal that can satisfy the above-mentioned qualities of TiN, in addition to having lower resistivity than TiN, is molybdenum. However, molybdenum deposited directly on gate oxide (e.g., SiO2) using some process (e.g., atomic layer deposition (ALD)) may not form a stable interface (e.g., electrically stable, chemically stable), but using a selective metal deposition process can provide a relatively stable interface.

The systems and methods described herein may incorporate and/or may be based on selective metal deposition, which can include techniques where metal atoms are deposited only on specific targeted areas of a surface. Selective metal deposition can allow for precise patterning of metal films by selectively choosing where the metal will adhere, while preventing deposition on unwanted areas, which can be achieved through chemical interactions with the substrate and/or by using a patterned mask. Methods of selective metal deposition can include chemical vapor deposition (CVD), atomic layer deposition (ALD), utilizing self-assembled monolayers and/or polymer masks to selectively block metal deposition over some areas.

Accordingly, the systems and methods described herein may be based on and/or may include depositing a first metal (e.g., TiN) as a seed metal, etching a portion of the first metal, and selectively depositing a second metal (e.g., molybdenum) on the seed metal for the wordline (e.g., based on 3D DRAM pitch constraints). The wordline can include an electrical conductor that runs across a row of memory cells, controlling access to each individual cell within that row by applying a voltage to select the desired cell for a read or write.

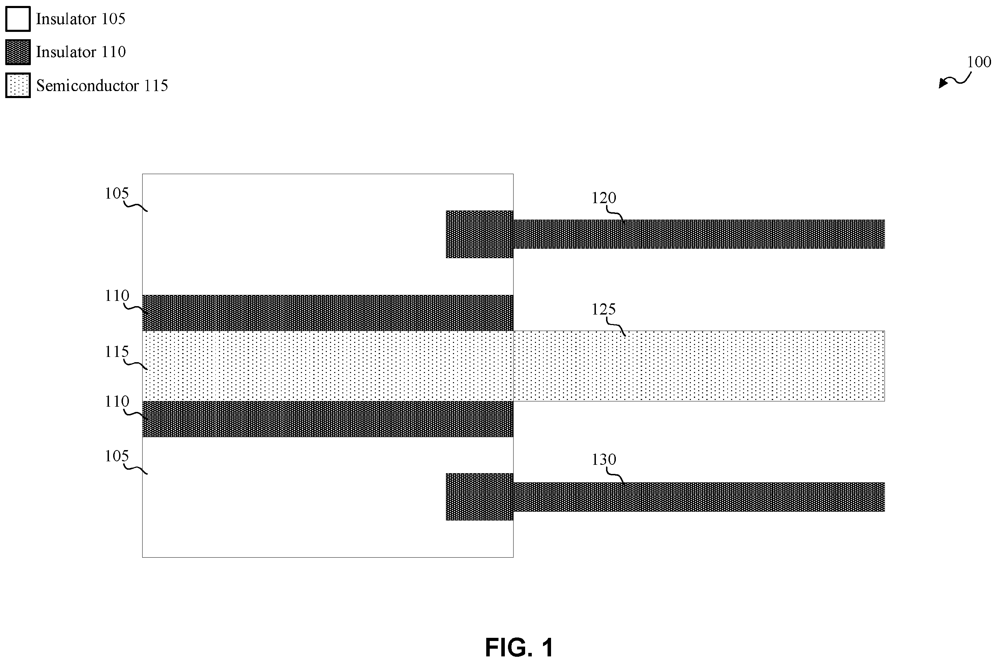

FIG. 1 illustrates a cross-sectional view illustrating an example of a device 100 (e.g., semiconductor device) in accordance with one or more implementations as described herein. FIG. 1 illustrates at least a portion of a semiconductor device fabrication process resulting in an improved memory cell transistor structure, enabling the systems and methods described herein of selective metal deposition for memory cell transistors. In some cases, device 100 may depict a gate oxide pre-clean stage. In some cases, FIG. 1 may depict a cross-section (e.g., slice view) of elements of device 100 (e.g., elements of a transistor fabrication). Thus, the depicted elements may extend outward and/or may extend inward from the depicted view. Similarly, the depicted elements may repeat themselves upward and/or may repeat themselves downward from the depicted view.

The configuration of device 100 may enable formation of a gate around a semiconductor channel (e.g., semiconductor 115) to form a transistor. In the illustrated example, device 100 may include insulator 105 (e.g., a first spacer insulator such as a nitride insulator and/or oxide insulator), insulator 110 (e.g., a second spacer insulator such as an oxide insulator and/or nitride insulator), and semiconductor 115 (e.g., silicon channel). As shown, device 100 may include inter-tier dielectric 120 and inter-tier dielectric 130. In some cases, inter-tier dielectric 120 and inter-tier dielectric 130 may separate wordlines above and/or below the depicted portion of device 100. As shown, semiconductor 115 may include a semiconductor channel 125. Semiconductor channel 125 may include an extension of semiconductor 115 (e.g., extension of silicon) that extends out from a depicted right-side edge of semiconductor 115. Although a line is depicted between semiconductor 115 and semiconductor channel 125, semiconductor channel 125 and semiconductor 115 may include a continuous segment of semiconductive material (e.g., silicon).

The gate oxide pre-clean stage may depict a dual-insulator configuration. In some examples, insulator 105 may include a nitride insulator and/or an oxide insulator. For example, at least a portion of insulator 105 may use a nitride insulator. Additionally, or alternatively, at least a portion of insulator 105 may use an oxide insulator. In some cases, insulator 110 may include an oxide insulator and/or a nitride insulator. For example, at least a portion of insulator 110 may be a nitride insulator. Additionally, or alternatively, at least a portion of insulator 110 may be an oxide insulator

In some examples, the depicted gate oxide pre-clean stage of device 100 may include spacer materials such as insulator 105, insulator 110, inter-tier dielectric 120, and/or inter-tier dielectric 130. In some cases, the spacer materials may be based on a first insulator and/or a second insulator, which may include at least one of a nitride insulator or an oxide insulator (e.g., first insulator includes a nitride insulator, second insulator includes an oxide insulator, or vice versa). The spacer material of insulator 105, insulator 110, inter-tier dielectric 120, and/or inter-tier dielectric 130 may include at least one insulator material, such as silicon nitride (SiN), silicon oxycarbide (SiOC), silicon dioxide (SiO2), etc. For example, insulator 105, insulator 110, inter-tier dielectric 120, and/or inter-tier dielectric 130 may include a nitride insulator, which may include silicon nitride, gallium nitride, aluminum nitride, boron nitride, etc. Additionally, or alternatively, insulator 105, insulator 110, inter-tier dielectric 120, and/or inter-tier dielectric 130 may include an oxide insulator, which may include silicon dioxide, aluminum oxide (Al2O3), hafnium oxide (HfO2), titanium dioxide (TiO2), etc.

In some cases, a transistor and capacitor may be formed on a semiconductor channel (e.g., semiconductor 115, silicon channel). In some cases, a transistor may be fabricated in the open areas between inter-tier dielectric 120, semiconductor channel 125, and/or inter-tier dielectric 130, whereas a capacitor may be fabricated in the area between two insulators 110, and/or semiconductor 115. Based on the systems and methods described herein, isolation may be formed between semiconductor channel layers to enable each transistor to be accessed independently. A capacitor may be formed on the left side of device 100 based on the depicted view. In some cases, device 100 may include multiple semiconductor channel layers (e.g., from 50 to 300 layers in the vertical direction relative to the depicted view). In some cases, a first semiconductor channel layer of device 100 (e.g., semiconductor 115) and a second semiconductor channel layer of device 100 may be around 50 nanometers (nm) to 200 nm apart. Examples of semiconductor 115 may include at least one of silicon, gallium, germanium, arsenide, etc. In some cases, a semiconductor of device 100 may be doped with impurities to create n-type (electron-rich) and/or p-type (hole-rich) semiconductors.

In some cases, one or more materials of device 100 may be formed based on deposition. In semiconductor chip manufacturing, deposition can include a fabrication process that involves applying thin layers of materials (e.g., applied over inter-tier dielectric 120, inter-tier dielectric 130, and/or semiconductor channel 125, etc.). Deposition can include applying layers of a material at the atomic and/or molecular level. Some techniques used in deposition may include: physical vapor deposition (PVD) to deposit metal films without a chemical reaction, chemical vapor deposition (CVD) using external energy to apply thin films to semiconductors, insulators, and conductors, electrochemical deposition (ECD) to create metal wirings (e.g., copper wirings) that links devices in an integrated circuit, atomic layer deposition (ALD) to add layers of atoms at a time, and so on.

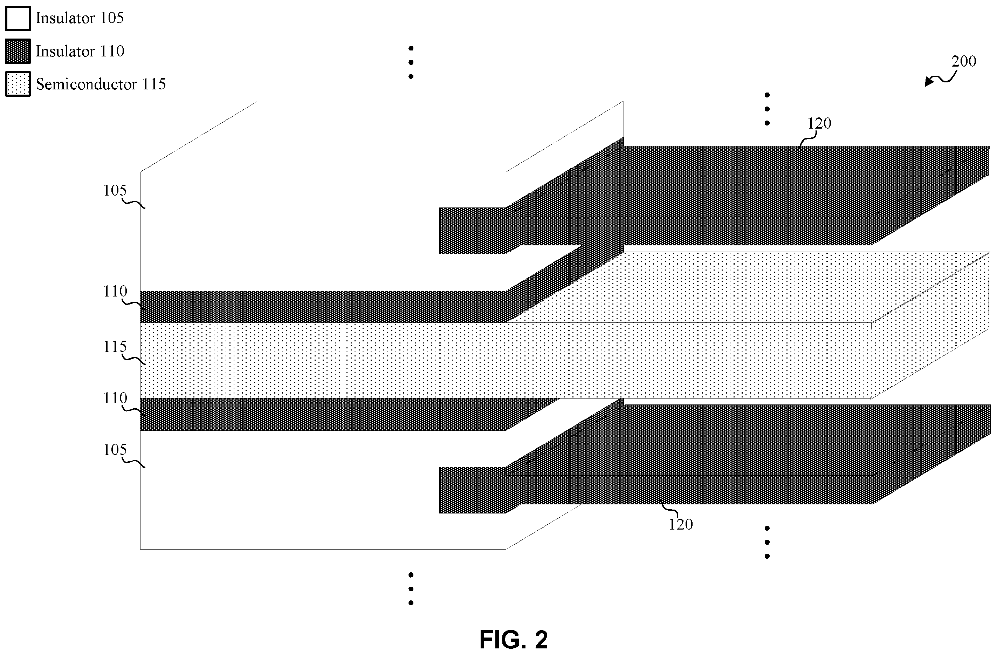

FIG. 2 illustrates a three-dimensional view illustrating an example of a device 200 (e.g., a semiconductor device) in accordance with one or more implementations as described herein. FIG. 2 illustrates at least a portion of a semiconductor device fabrication process resulting in an improved memory cell transistor structure, enabling the systems and methods described herein of selective metal deposition for memory cell transistors. In the illustrated example, semiconductor device 200 may be based on semiconductor device 100 of FIG. 1. In some cases, FIG. 2 may depict a cross-section (e.g., slice view) of elements of device 200 (e.g., elements of a transistor fabrication). Thus, the depicted elements may extend outward and/or may extend inward from the depicted view with some inter-layer dielectric separating the left side of semiconductor 115 (e.g., where a capacitor element may be added). Similarly, the depicted elements may repeat themselves upward and/or may repeat themselves downward from the depicted view.

In the illustrated example, device 200 may depict a three-dimensional view of device 100 of FIG. 1. It is noted that the three-dimensional view of device 200 may apply to the depicted cross-sectional view of one or more of the devices described and/or depicted herein. As shown, insulator 105 may include a block of material from which extends a first instance of inter-tier dielectric 120. Aa shown, a first portion of insulator 110 may be formed between a first instance of insulator 105 and semiconductor 115. A second portion of insulator 110 may be positioned between semiconductor 115 and a second instance of insulator 105, from which extends a second instance of inter-tier dielectric 120. In some cases, device 200 may continue with additional elements or layers above and/or additional elements or layers below with respect to the perspective view of device 200.

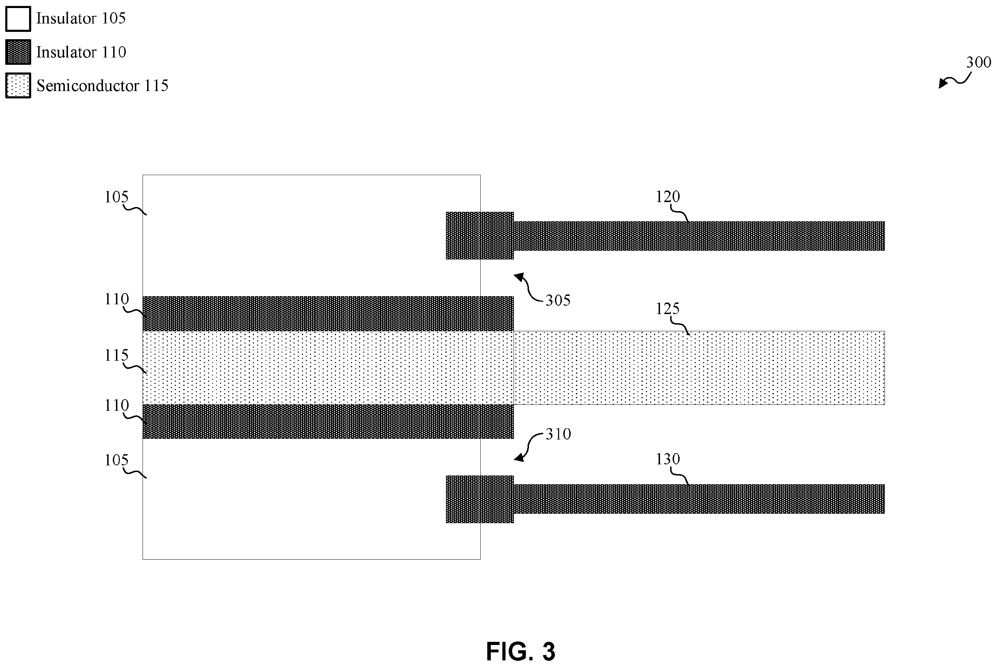

FIG. 3 illustrates a cross-sectional view illustrating an example of a device 300 (e.g., a semiconductor device) in accordance with one or more implementations as described herein. FIG. 3 illustrates at least a portion of a semiconductor device fabrication process resulting in an improved memory cell transistor structure, enabling the systems and methods described herein of selective metal deposition for memory cell transistors. In the illustrated example, semiconductor device 300 may be based on semiconductor device 200 of FIG. 2. In some cases, FIG. 3 may depict a cross-section (e.g., slice view) of elements of device 300 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 300 may depict an etch back of at least a portion of a spacer insulator. In some cases, device 300 may be based on an etch back of a nitride insulator of device 200. For example, device 300 may depict an etch back of insulator 105. As shown, a portion of insulator 105 above the depicted inter-tier dielectric 120 is etched back and a portion of insulator 105 below the depicted inter-tier dielectric 120 is etched back. Similarly, a portion of insulator 105 above the depicted inter-tier dielectric 130 is etched back and a portion of insulator 105 below the depicted inter-tier dielectric 130 is etched back.

In some cases, etching back insulator 105 may form one or more recesses in device 300. For example, a recess 305 may be formed between inter-tier dielectric 120 and the depicted upper portion of insulator 110, and a recess 310 may be formed between inter-tier dielectric 130 and the depicted lower portion of insulator 110. Similarly, one or more additional recesses may be formed above inter-tier dielectric 120 and/or below inter-tier dielectric 130. In some cases, recess 305 and/or recess 310 may provide a recess (e.g., gap, pocket) for metal deposition. In some examples, the height and/or width of recess 305 and/or recess 310 may range from 1 to 100 nm.

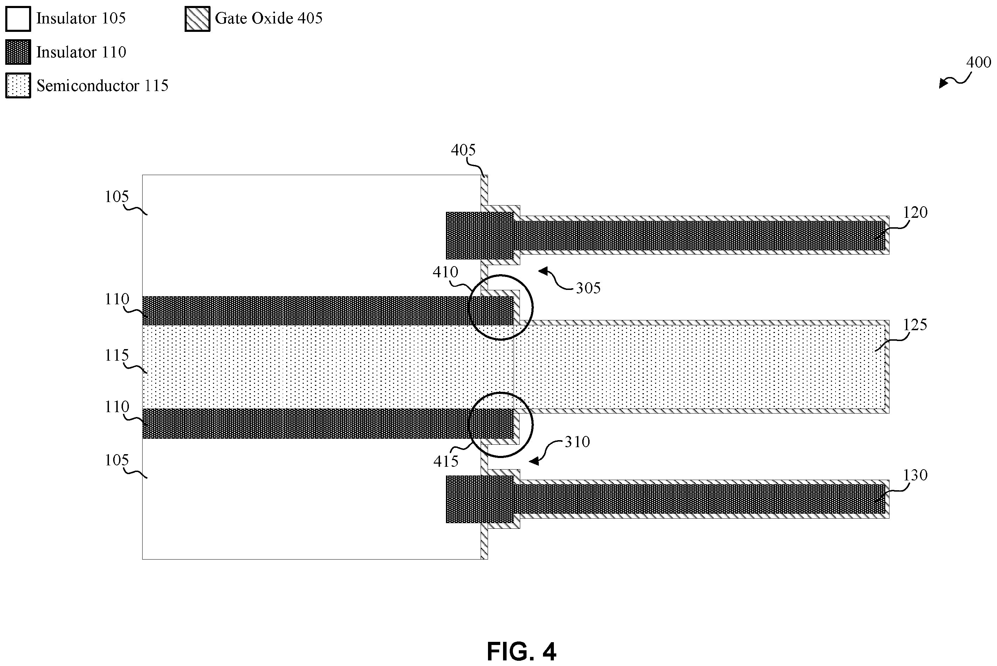

**FIG.** 4 illustrates a cross-sectional view illustrating an example of a device 400 (e.g., a semiconductor device) in accordance with one or more implementations as described herein. FIG. 4 illustrates at least a portion of a semiconductor device fabrication process resulting in an improved memory cell transistor structure, enabling the systems and methods described herein of selective metal deposition for memory cell transistors. In the illustrated example, semiconductor device 400 may be based on semiconductor device 300 of FIG. 3. In some cases, FIG. 4 may depict a cross-section (e.g., slice view) of elements of device 400 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 400 may include gate oxide 405. In some cases, device 400 may depict a deposition of gate oxide 405 over one or more elements of device 300 (e.g., over insulator 105, insulator 110, inter-tier dielectric 120, semiconductor channel 125, inter-tier dielectric 130, recess 305, recess 310). In some cases, gate oxide 405 may range from 0.5 nm to 20 nm in thickness. In some cases, a thickness of insulator 110 may range from 0.5 nm to 20nm.

In some aspects of the disclosed systems and methods, gate oxide 405 may include any insulator material (e.g., any compatible gate oxide insulator material). For example, gate oxide 405 may include silicon oxycarbide, silicon dioxide, aluminum oxide, hafnium oxide, titanium dioxide, etc. In some cases, gate oxide 405 may include any material with a relatively high dielectric constant (e.g., high-κ dielectric), or any gate oxide insulator material that forms a compatible interface with a semiconductor, such as semiconductor 115 (e.g., silicon).

A capacitor may be formed to the left of the depicted device 400. The level or degree to which data may be retained in the capacitor may be based on the leakage rate. Leakage of data can occur from the capacitor towards the transistor side (e.g., towards the depicted portion of device 400, towards semiconductor 115, semiconductor channel 125, etc.). The higher the rate of leakage, the more often the capacitors must be refreshed to maintain data integrity. However, refresh operations in DRAM can negatively impact performance and power dissipation by requiring periodic cycles where a portion of the memory is unavailable for data access while the stored charges are being replenished, leading to potential stalls in memory requests and consuming additional power to perform the refresh operation. Thus, the more frequent the refresh cycles, the greater the performance penalty and power consumption.

As shown, based on the formation of gate oxide 405, a thickness of oxide between semiconductor channel 125 and recess 305 and/or recess 310 is thicker than other portions of oxide adjacent to semiconductor channel 125. For example, based on the recesses from the etch back of insulator 105 and the formation of gate oxide 405, the overall thickness of the oxide at 410 is based on the combination of gate oxide 405 and insulator 110, and the overall thickness of the oxide at 415 is based on the combination of gate oxide 405 and insulator 110. Thus, the thickness of the oxide at 410 and at 415 is thicker than the rest of gate oxide 405 alone.

It is noted that the elements of device 400 are depicted for ease of identification of elements and the depicted thickness of one element (e.g., insulator 110) compared to the thickness of another element (e.g., gate oxide 405) is not necessarily depicted in a relative scale. For example, although insulator 110 is depicted as being thicker than gate oxide 405, gate oxide 405 may be thicker than insulator 110 in some implementations, etc. For example, insulator 110 relative to 410 may have a thickness of 5 nm (e.g., 5 nm thickness from top to bottom based on the depicted view of insulator 110), and gate oxide 405 may be formed with a thickness of 10 nm over the elements of device 400 as shown. As a result, the thickness of the insulator 110 and the thickness of gate oxide 405 provide a thicker overall oxide thickness (e.g., 10nm + 5nm = 15nm) between semiconductor channel 125 and recess 305 at 410. The thicker oxide at 410 and/or at 415 may help reduce an electric field associated with metal gates of device 400, which can reduce leakage.

Accordingly, to reduce the rate of leakage, the oxide portion adjacent to or relatively near recess 305 and/or recess 310 may be fabricated to have a greater overall oxide thickness compared to other portions of the oxide (e.g., the oxide over the semiconductor channel 125). This thicker oxide portion helps reduce the electric field in this region, which helps reduce leakage. By reducing leakage, the refresh rate can be reduced while still maintaining data integrity. As a result, the reduced refresh rate reduces the power draw of DRAM and increases memory cell availability. Thus, the thicker oxide improves the performance of DRAM while reducing power consumption. Moreover, keeping a remaining portion of the semiconductor channel 125 with thinner gate oxide 410 maintains the gate control and drive strength of the majority of transistor gate length.

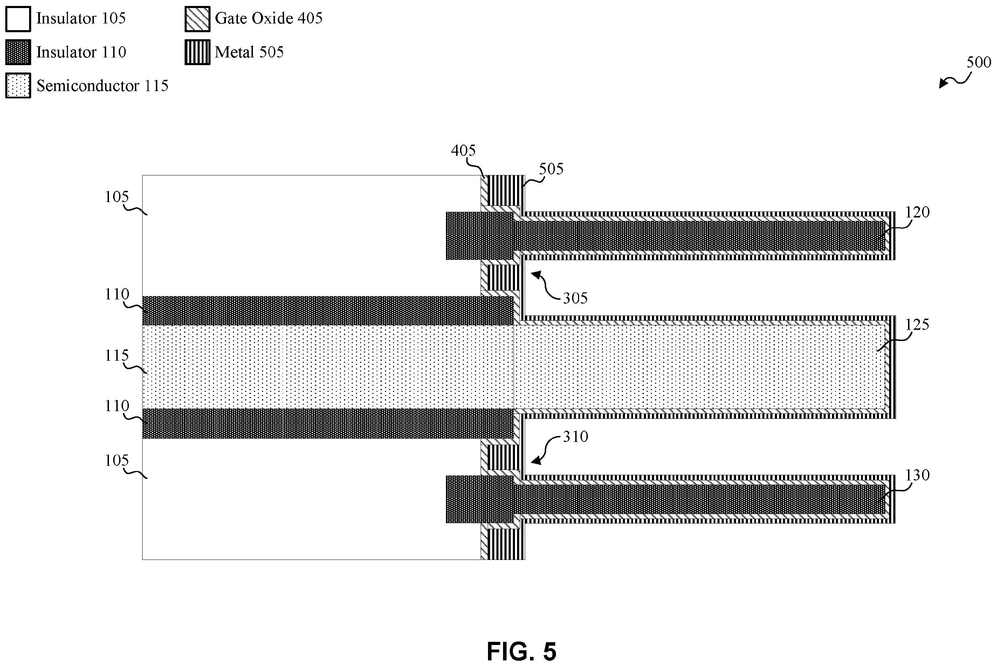

**FIG. 5** illustrates a cross-sectional view illustrating an example of a device 500 (e.g., a semiconductor device) in accordance with one or more implementations as described herein. FIG. **5** illustrates at least a portion of a semiconductor device fabrication process resulting in an improved memory cell transistor structure, enabling the systems and methods described herein of selective metal deposition for memory cell transistors. In the illustrated example, semiconductor device 500 may be based on semiconductor device 400 of FIG. 4. In some cases, FIG. 5 may depict a cross-section (e.g., slice view) of elements of device 500 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 500 may include metal 505. For example, device 500 may depict a thin seed layer deposition of metal (e.g., metal 505). In some cases, device 500 may depict a deposition of metal 505 over one or more elements of device 400 (e.g., over gate oxide 405). In some cases, metal 505 may range from 0.5 nm to 100 nm in thickness. In some cases, deposition of metal 505 may depict a first metal deposition of multiple metal depositions (e.g., depositions of at least two different metals).

In the illustrated example, the seed layer deposition may include deposition of metal 505 over gate oxide 405. In some cases, metal 505 may be deposited over recess 305 and/or recess 310. In some examples, metal 505 may fill at least a portion of recess 305 and/or fill at least a portion of recess 310. As shown, metal 505 may completely fill recess 305 and/or recess 310 (e.g., overflow recess 305 and/or recess 310, exceed a depth or upper edge of recess 305 and/or recess 310).

In some cases, metal 505 may be deposited as at least a portion of a gate metal. In some cases, a gate metal may include titanium, tungsten, tantalum, titanium nitride, tungsten nitride, tantalum nitride, etc. In some cases, metal 505 may include any suitable metal that acts as a compatible seed layer for selective metal deposition of wordline metal. In some cases, deposition of metal 505 may include deposition of a thin layer of TiN. In some cases, deposition of metal 505 may include deposition of a first metal (e.g., TiN), where the first metal is deposited as a seed layer for selective metal deposition of a second metal (e.g., molybdenum). In some examples, material used for selective metal deposition may include tungsten grown on a tungsten seed layer, cobalt grown on a tungsten seed layer or on a cobalt seed layer, titanium nitride grown on a titanium nitride seed layer, titanium grown on a titanium nitride seed layer, etc.

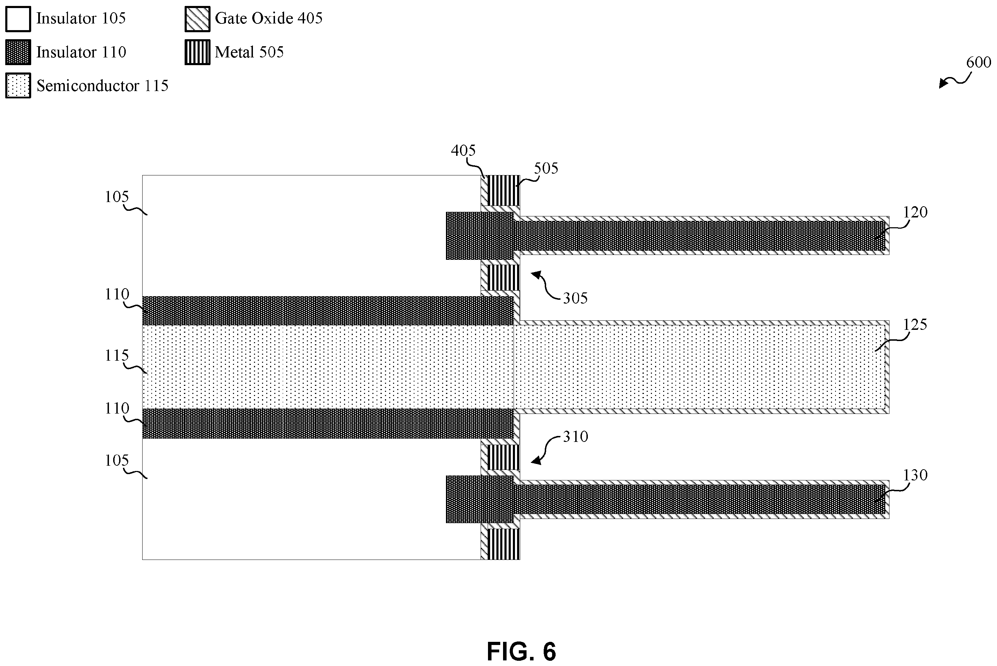

**FIG. 6** illustrates a cross-sectional view illustrating an example of a device 600 (e.g., a semiconductor device) in accordance with one or more implementations as described herein. FIG. **6** illustrates at least a portion of a semiconductor device fabrication process resulting in an improved memory cell transistor structure, enabling the systems and methods described herein of selective metal deposition for memory cell transistors. In the illustrated example, semiconductor device 600 may be based on semiconductor device 500 of FIG. 5. In some cases, FIG. 6 may depict a cross-section (e.g., slice view) of elements of device 600 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 600 may depict a seed layer etch back. In some cases, device 600 may depict an etch back of at least a portion of metal deposited on device 500. For example, device 600 may depict an etch back of metal 505. As shown, a portion of metal 505 above the depicted inter-tier dielectric 120 and a portion of metal 505 below the depicted inter-tier dielectric 120 may be etched back. Similarly, a portion of metal 505 above the depicted inter-tier dielectric 130 and a portion of metal 505 below the depicted inter-tier dielectric 130 may be etched back.

As shown, the etch back of metal 505 may etch the metal deposition over all exposed surfaces, leaving a remaining portion of metal 505 in recess 305 and recess 310. Based on the systems and methods of selective metal deposition for memory cell transistors described herein, metal 505 in recess 305 and metal 505 in recess 310 may be used as a seed layer of a second metal deposition.

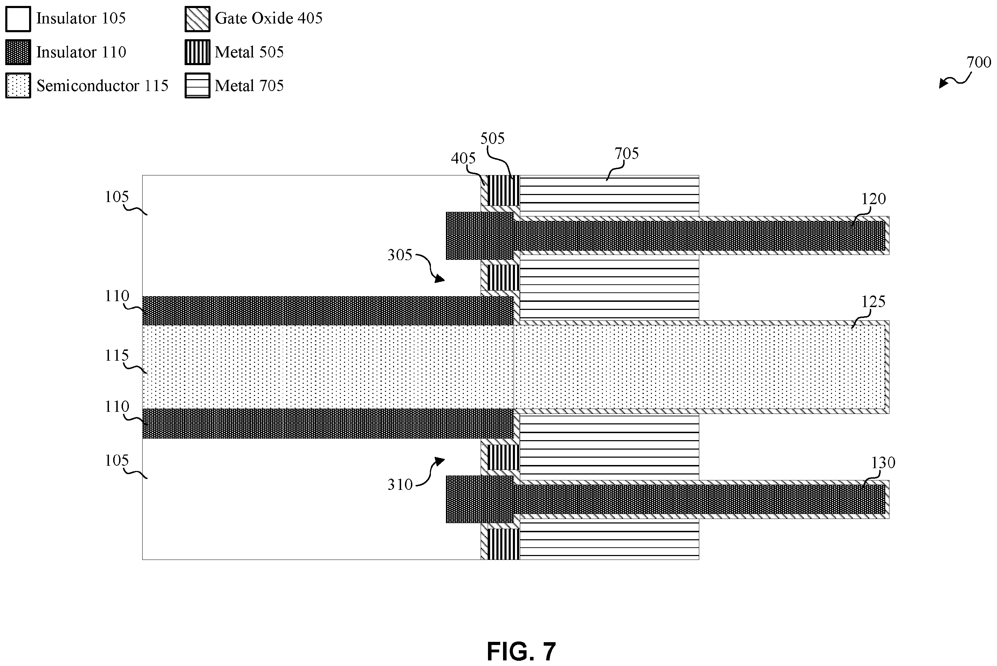

**FIG. 7** illustrates a cross-sectional view illustrating an example of a device 700 (e.g., a semiconductor device) in accordance with one or more implementations as described herein. FIG. 7 illustrates at least a portion of a semiconductor device fabrication process resulting in an improved memory cell transistor structure, enabling the systems and methods described herein of selective metal deposition for memory cell transistors. In the illustrated example, semiconductor device 700 may be based on semiconductor device 600 of FIG. 6. In some cases, FIG. 7 may depict a cross-section (e.g., slice view) of elements of device 700 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 700 may include metal 705. In some cases, device 700 may depict deposition of metal (e.g., metal 705) over one or more elements of device 600. For example, device 700 may depict selective deposition of metal 705 over portions of device 600 (e.g., over metal 505 in recess 305, metal 505 in recess 310, etc.). In some cases, metal 505 and metal 705 may be part of a metal gate of device 700. Selective metal deposition can include a process where metal atoms are deposited only on specific targeted areas of a surface, allowing for precise patterning of a metal layer on a substrate, essentially selecting where the metal is deposited, while preventing deposition on unwanted areas.

As shown, metal 705 may be selectively deposited on metal 505 in recess 305 and fill up a space between inter-tier dielectric 120 and semiconductor channel 125. Similarly, metal 705 may be selectively deposited on metal 505 in recess 310 and fill up a space between inter-tier dielectric 130 and semiconductor channel 125. As shown, metal 705 may be selectively deposited on other portions of metal 505 in recesses above inter-tier dielectric 120 and/or deposited on other portions of metal 505 in recesses below inter-tier dielectric 130.

In some cases, a first metal (e.g., metal 505, TiN) may be deposited as a seed layer, and a second metal (e.g., metal 705, molybdenum) may be selectively deposited on the seed layer of metal 505. As shown, metal 505 may make up a relatively small portion of the gate length, while metal 705 may be deposited as a majority portion of the gate length (e.g., greater than 50%).

Using molybdenum as a majority of a gate metal (e.g., using molybdenum for metal 705) can significantly reduce wordline resistance for device 700 (e.g., compared to using only TiN) based on the relatively low resistivity of molybdenum.

Using selective deposition to deposit metal 705 is a relatively low-cost and low-complexity fabrication process, making the deposition of metal 705 a cost-effective solution to lowering resistivity of device 700. Lowering the resistivity of device 700 helps increase switch speeds of device 700.

In some cases, device 700 may be configured as DRAM. Thus, increasing the switch speeds of device 700 can increase the switch speeds of DRAM. Increasing DRAM switch speeds provides faster data transfer rates, meaning the DRAM can read and write information quicker, leading to improved overall system performance, especially in memory-intensive tasks, such as artificial intelligence (AI) computing, gaming, video editing, multitasking, etc.

In some cases, the lower the resistivity, the better electrical properties of device 700. For example, the lower resistivity of metal 705 may reduce propagation delay associated with the metal 705. In some cases, metal 705 may be configured as the gate of a transistor of device 700, but may effectively act as a wire with propagation delay. By reducing the resistivity of the gate material (e.g., via lower resistivity of metal 705), the resistance of the gate of the transistor is reduced, thus improving the speed of electrical signals and increasing the switching speed of the transistor.

In some cases, metal 705 may include molybdenum and metal 505 may include TiN. Molybdenum has a higher work function than TiN. The higher work function of metal 705 increases a threshold voltage of the transistor configuration of device 700 (e.g., DRAM access transistor), which in turn helps lower VBB2 bias to maintain a same off-state current (IOFF) regime.

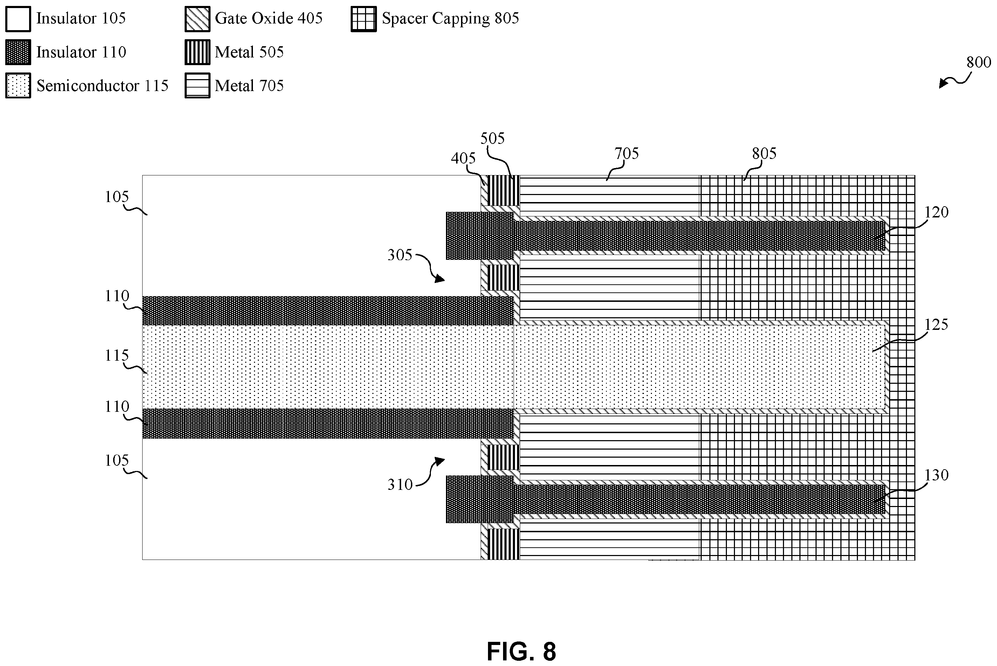

**FIG. 8** illustrates a cross-sectional view illustrating an example of a device 800 (e.g., a semiconductor device) in accordance with one or more implementations as described herein. FIG. 8 illustrates at least a portion of a semiconductor device fabrication process resulting in an improved memory cell transistor structure, enabling the systems and methods described herein of selective metal deposition for memory cell transistors. In the illustrated example, semiconductor device 800 may be based on semiconductor device 700 of FIG. 7. In some cases, FIG. 8 may depict a cross-section (e.g., slice view) of elements of device 800 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 800 may include spacer capping 805. In some cases, device 800 may depict deposition of a capping material (e.g., spacer capping 805) over one or more elements of device 700 (e.g., over metal 705, gate oxide 405). In some cases, spacer capping 805 may include silicon nitride. Spacer capping 805 may enable process steps to complete transistor device fabrication.

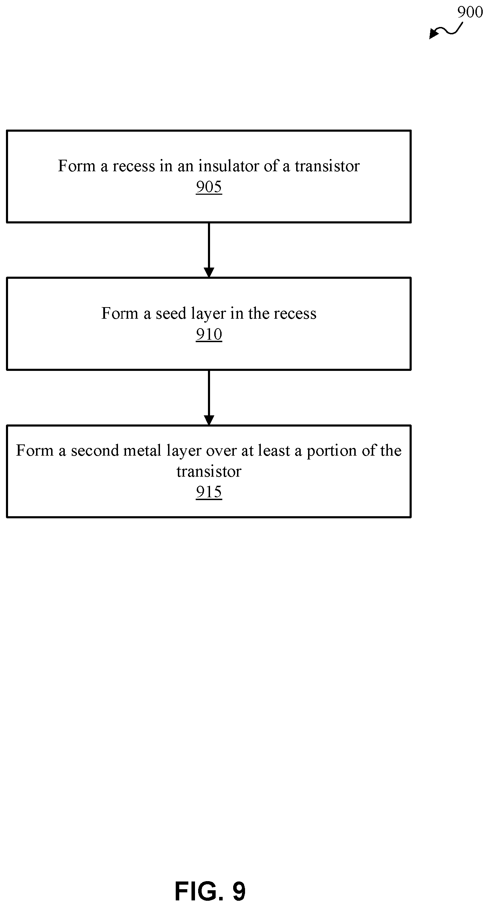

**FIG. 9** depicts a flow diagram illustrating an example method 900 associated with the disclosed systems, in accordance with example implementations described herein. In some configurations, the method 900 may be implemented by one or more semiconductor fabrication devices. The method 900 is just one implementation and one or more operations of the method 900 may be rearranged, reordered, omitted, and/or otherwise modified such that other implementations are possible and contemplated.

At 905, method 900 may include forming a recess in a first insulator of a transistor. For example, method 900 may include forming a recess based on etching a portion of the first insulator.

At 910, method 900 may include forming a seed layer in the recess. For example, method 900 may include forming a seed layer of a first metal in the recess.

At 915, method 900 may include forming a second metal layer over at least a portion of the transistor. For example, method 900 may include selectively depositing a second metal on the seed layer of the first metal in the recess.

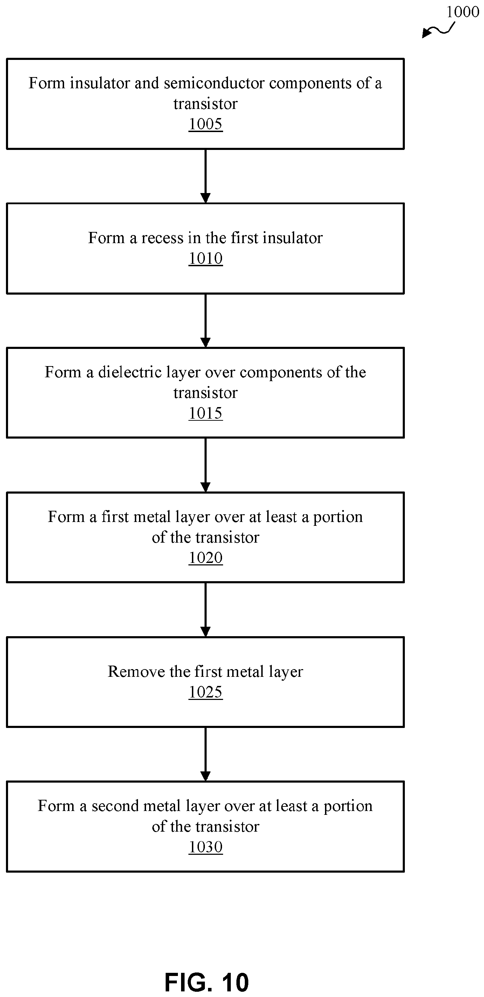

**FIG. 10** depicts a flow diagram illustrating an example method 1000 associated with the disclosed systems, in accordance with example implementations described herein. In some configurations, the method 1000 may be implemented by one or more semiconductor fabrication devices. The method 1000 is just one implementation and one or more operations of the method 1000 may be rearranged, reordered, omitted, and/or otherwise modified such that other implementations are possible and contemplated.

At 1005, method 1000 may include forming insulator and semiconductor components of a transistor. For example, method 1000 may include forming a first insulator, a second insulator, and a semiconductor channel of the transistor.

At 1010, method 1000 may include forming a recess in the first insulator. For example, method 1000 may include forming a recess based on etching a portion of the first insulator.

At 1015, method 1000 may include forming a dielectric layer over components of the transistor. For example, method 1000 may include forming a layer of an oxide over at least one of a surface of the first insulator, a surface of the second insulator, a surface of the recess, or a surface of the semiconductor channel.

At 1020, method 1000 may include forming a first metal layer over at least a portion of the transistor. For example, method 1000 may include depositing a first metal over the oxide.

At 1025, method 1000 may include removing the first metal layer. For example, method 1000 may include etching back a first portion of the first metal.

At 1030, method 1000 may include forming a second metal layer over at least a portion of the transistor. For example, method 1000 may include selectively depositing a second metal on the first metal in the recess.

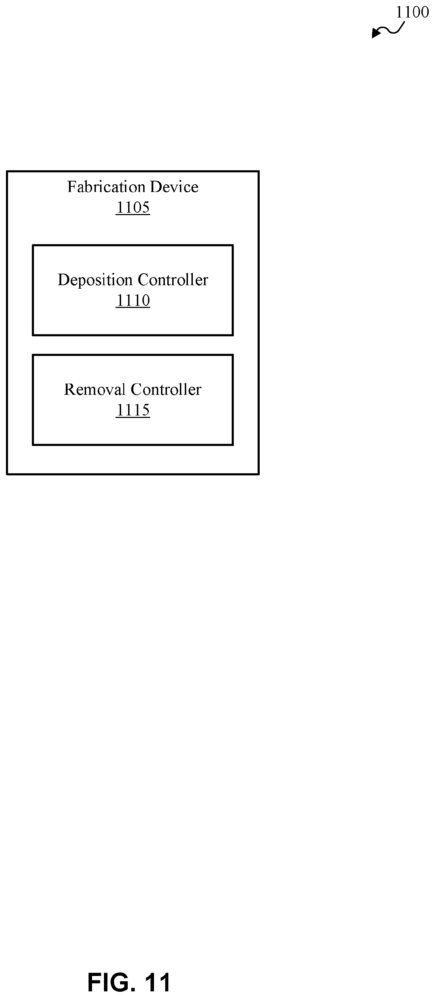

**FIG. 11** illustrates an example system 1100 in accordance with one or more implementations as described herein. As shown, system 1100 may include fabrication device 1105. Fabrication device 1105 may include any one or a combination of logic (e.g., logical circuit), hardware (e.g., processing unit, memory, storage), software, firmware, and the like, that enable fabrication device 1105 to provide the systems and methods described herein of selective metal deposition for memory cell transistors.

In the illustrated example, fabrication device 1105 may include deposition controller 1110 and removal controller 1115. In some cases, deposition controller 1110 and/or removal controller 1115 may include any one or combination of logic (e.g., logical circuit), hardware (e.g., processing unit, memory, storage), software, firmware, and the like.

Deposition controller 1110 may include a control system that manages the parameters of a deposition process, where a thin layer of material is deposited onto a wafer to create the electronic components within an integrated circuit (IC). Deposition controller 1110 may regulate factors like temperature, gas flow, pressure, and plasma conditions to ensure the deposited film has the desired properties and thickness for optimal device performance. Deposition controller 1110 may provide chemical vapor deposition (CVD) where precursor gases react on the wafer surface to form a solid film; plasma enhanced CVD (PECVD) where plasma is used to enhance chemical reactions, enabling deposition at lower temperatures; and/or atomic layer deposition (ALD), where a single layer of atoms may be deposited at a time.

Removal controller 1115 may control the process of removing material from a wafer during etching, which may include dry etching and/or plasma etching, ensuring that only the desired areas are removed with the correct depth and precision to create the desired circuit features on a given chip. Removal controller 1115 may manage the rate and selectivity of material removal during the etching step.

In the examples described herein, the configurations and operations are example configurations and operations, and may involve various additional configurations and operations not explicitly illustrated. In some examples, one or more aspects of the illustrated configurations and/or operations may be omitted. In some embodiments, one or more of the operations may be performed by components other than those illustrated herein. Additionally, or alternatively, the sequential and/or temporal order of the operations may be varied.

Certain embodiments may be implemented in one or a combination of hardware, firmware, and software. Other embodiments may be implemented as instructions stored on a computer-readable storage device, which may be read and executed by at least one processor to perform the operations described herein. A computer-readable storage device may include any non-transitory memory mechanism for storing information in a form readable by a machine (e.g., a computer). For example, a computer-readable storage device may include read-only memory (ROM), random-access memory (RAM), magnetic disk storage media, optical storage media, flash-memory devices, and other storage devices and media.

The word "exemplary" may be used herein to mean "serving as an example, instance, or illustration." Any embodiment described herein as "exemplary" is not necessarily to be construed as preferred or advantageous over other embodiments.

Although an example processing system has been described above, embodiments of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more components of computer program instructions, encoded on computer storage medium for execution by, or to control the operation of, information/data processing apparatus. Alternatively, or in addition, the program instructions can be encoded on an artificially-generated propagated signal, for example a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (for example multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, for example an FPGA (field programmable gate array) or an ASIC (application-specific integrated circuit). The apparatus can also include, in addition to hardware, code that creates an execution environment for the computer program in question, for example code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a component, component, subroutine, object, or other unit suitable for use in a computing environment. A computer program may, but need not, correspond to a file in a file system. A program can be stored in a portion of a file that holds other programs or information/data (for example one or more scripts stored in a markup language document), in a single file dedicated to the program in question, or in multiple coordinated files (for example files that store one or more components, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, for example magnetic, magneto-optical disks, or optical disks. However, a computer need not have such devices. Devices suitable for storing computer program instructions and information/data include all forms of non-volatile memory, media and memory devices, including by way of example semiconductor memory devices, for example EPROM, EEPROM, and flash memory devices; magnetic disks, for example internal hard disks or removable disks; magneto-optical disks; and CD-ROM and DVD-ROM disks. The processor and the memory can be supplemented by, or incorporated in, special purpose logic circuitry.

Embodiments of the subject matter described herein can be implemented in a computing system that includes a back-end component, for example as an information/data server, or that includes a middleware component, for example an application server, or that includes a front-end component, for example a client computer having a graphical user interface or a web browser through which a user can interact with an embodiment of the subject matter described herein, or any combination of one or more such back-end, middleware, or front-end components. The components of the system can be interconnected by any form or medium of digital information/data communication, for example a communication network. Examples of communication networks include a local area network ("LAN") and a wide area network ("WAN"), an inter-network (for example the Internet), and peer-to-peer networks (for example ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (for example an HTML page) to a client device (for example for purposes of displaying information/data to and receiving user input from a user interacting with the client device). Information/data generated at the client device (for example a result of the user interaction) can be received from the client device at the server.

While this specification contains many specific embodiment details, these should not be construed as limitations on the scope of any embodiment or of what may be claimed, but rather as descriptions of features specific to particular embodiments. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain embodiments, multitasking and parallel processing may be advantageous.

Many modifications and other examples as set forth herein will come to mind to one skilled in the art to which these embodiments pertain having the benefit of the teachings presented in the foregoing descriptions and the associated drawings. Therefore, it is to be understood that the embodiments are not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A method of fabrication of a transistor of a memory cell, the method comprising:
forming (1005) a first insulator (105), a second insulator (110), and a semiconductor channel (125) of the transistor;
forming (1010) a recess (305) based on removing a portion of the first insulator (105);
forming (1015) a dielectric layer (405) over at least one of a surface of the first insulator (105), a surface of the second insulator (110), a surface of the recess (305), or a surface of the semiconductor channel (125);
forming (1020) a first metal layer (505) over the dielectric layer (405);
removing (1025) a first portion of the first metal layer (505); and
selectively forming a second metal layer (705) on the first metal layer (505) in the recess (305).

2. The method of claim 1, wherein a second portion of the first metal layer (505) remains in the recess (305) after removing the first portion of the first metal layer (505).

3. The method of claim 2, wherein the second portion of the first metal layer (505) is a seed layer of the second metal layer (705).

4. The method of any one of claims 1, wherein the first metal layer (505) in the recess (305) is a seed that enables the second metal layer (705) to grow between the semiconductor channel (125) and an inter-tier dielectric (120) that extends from the first insulator (105).

5. The method of claim 4, wherein the recess (305) is formed between a portion of the second insulator (110) and a portion of the inter-tier dielectric (120), and/or wherein the recess (305) is adjacent to an end portion of the second insulator (110) that is adjacent to the semiconductor channel (125).

6. The method of any one of claims 1 to 5, wherein the dielectric layer (405) is formed as a gate oxide of the transistor.

7. The method of any one of claims 1 to 6, further comprising forming a spacer capping (805) over the second metal layer (705) and the dielectric layer (405).

8. The method of any one of claims 1 to 7, wherein at least one of the first insulator (105) or the second insulator (110) comprises at least one of a nitride insulator or an oxide insulator.

9. The method of any one of claims 1 to 8, wherein:
at least a portion of the second insulator (110) is formed adjacent to the first insulator (105) and a semiconductor (115) that includes the semiconductor channel (125).

10. A device comprising:
a first insulator (105);
an inter-tier dielectric (120) extending from the first insulator (105);
a second insulator (110) formed adjacent to the first insulator (105);
a semiconductor channel (125) formed adjacent to the second insulator (110);
a recess (305) that is formed based on removing a portion of the first insulator (105);
a dielectric layer (405) formed over at least one of a surface of the first insulator (105), a surface of the second insulator (110), a surface of the recess (305), or a surface of the semiconductor channel (125);
a first metal layer formed in the recess (305); and
a second metal layer selectively formed on the first metal layer in the recess (305).

11. The device of claim 10, wherein a second portion of the first metal layer remains in the recess (305) based on forming a first portion and the second portion of the first metal layer over the dielectric layer (405) and removing the first portion of the first metal layer.

12. The device of claim 11, wherein the second portion of the first metal layer is a seed layer of the second metal layer.

13. The device of any one of claims 10, wherein the first metal layer in the recess (305) is a seed layer that enables the second metal layer to grow between the semiconductor channel (125) and the inter-tier dielectric (120).

14. The device of any one of claims 10 to 13, wherein the recess (305) is formed between a portion of the second insulator (110) and a portion of the inter-tier dielectric (120), and/or
wherein the recess (305) is adjacent to an end portion of the second insulator (110) that is adjacent to the semiconductor channel (125).

15. The device of any one of claims 10 to 14, wherein the dielectric layer (405) is formed as a gate oxide of a transistor of the device.
